(19) Europäisches Patentamt

European Patent Office

Office européen des brevets

(11) **EP 1 548 455 A1**

(12) **DEMANDE DE BREVET EUROPEEN**

(43) Date de publication:
**29.06.2005 Bulletin 2005/26**

(51) Int Cl.[7]: **G01R 33/44**

(21) Numéro de dépôt: 04292896.0

(22) Date de dépôt: **06.12.2004**

(84) Etats contractants désignés:
**AT BE BG CH CY CZ DE DK EE ES FI FR GB GR HU IE IS IT LI LT LU MC NL PL PT RO SE SI SK TR**
Etats d'extension désignés:
**AL BA HR LV MK YU**

(30) Priorité: **17.12.2003 FR 0314961**

(71) Demandeur: **Institut Français du Pétrole**
**92852 Rueil-Malmaison Cedex (FR)**

(72) Inventeurs:
- **Lenormand, Roland**
  **92500 Rueil-Malmaison (FR)**
- **Fleury, Marc**
  **78170 La Celle Saint Cloud (FR)**
- **Egermann, Patrick**
  **92500 Rueil-Malmaison (FR)**

(54) **Détermination de la perméabilité d'un milieu souterrain à partir de mesures par RMN de la perméabilité de fragments de roche issu du milieu**

(57)  -Méthode pour déterminer la perméabilité d'un milieu souterrain à partir de mesures de diagraphies RMN et de la perméabilité de fragments de roche issus du milieu, qui est basée sur un étalonnage préalable de la perméabilité résultant de ces mesures, à partir de mesures directes sur des fragments de roche tels que des déblais de forage par exemple.

- La méthode comporte principalement une mesure de la perméabilité (k) à partir des fragments de roche, une mesure du signal produit par un dispositif d'analyse par RMN des fragments de roche préalablement saturés avec un liquide protoné (saumure par exemple), l'obtention des valeurs optimales des paramètres d'une relation donnant la perméabilité en fonction du signla RMN, et l'application de cette relation aux zones des puits ayant fait l'objet d'une diagraphie RMN mais pour lesquelles on ne dispose pas de mesures directes de perméabilité.

- Applications à l'évaluation d'un gisement en hydro-carbures par exemple.

**Fig.6**

## Description

La présente invention concerne une méthode pour déterminer la perméabilité d'un milieu souterrain à partir de mesures de diagraphie par RMN de la perméabilité de fragments de roche issus du milieu, qui est basée sur un étalonnage préalable de la perméabilité résultant de ces mesures, à partir de mesures directes sur des fragments de roche tels que des déblais de forage par exemple.

## I - ETAT DE LA TECHNIQUE

L'état de la technique est illustré par les publications suivantes qui seront rappelées pour certaines dans le cours de la description ci-après.

- Clark, R. K. et K. L. Bickham :"A mechanistic model for cuttings transport" , SPE n° 28306, 69th Annual Technical Conference and Exhibition, New Orleans ,25-28 September, 1994;

- Fleury, M. :"Validity of permeability prédiction from NMR measurements" , n° GERM Annual Meeting, La Pommeray, France.,14-18 May, 2001;

- Godefroy, S.: " Etudes RMN de la dynamique des molécules aux interfaces solide-liquide: des matériaux poreux calibrés aux roches réservoirs", Thèse de l'École Polytechnique, 2001;

- Kenyon, W. E. : "A three-part study of NMR longitudinal relaxation properties of water saturated sandstones", SPE Formation Evaluation, March, pp 622-636, 1989;

- Logan, W. D., J. P. Horkowitz, R. Laronga et al. : "Practical Application of NMR logging in carbonate reservoirs", SPE Reservoir Eval. & Eng., October, pp 438-448, 1998;

- Naegel, M., E. Pradié, T. Delahaye et al. :"Cuttings flow meters monitor hole cleaning in extended reach wells" , SPE n° 50677, European petroleum conference, The Hague, The Netherlands.,20-22 October, 1998;

- Nigh, E. et M. Taylor :"Wellsite determination of porosity and permeability using drilling cuttings" , C. W.-l. Society n° 10th Formation Evaluation Symposium1985;

- Pilehvari, A. A., J. J. Azar et S. A. Shirazi :"State-of-the-art cuttings transport in horizontal wellbores" , SPE n° 37079, International conference on horizontal well technology, Calgary, Canada., 18-20 November, 1996;

- Santarelli, F. J., A. F. Marsala, M. Brignoli et al. : " Formation evaluation from logging on cuttings", SPE Reservoir Eval. & Eng., June, pp 238-244, 1998;

- Seevers, D. O. :"A nuclear magnetic method for determining the permeability of sandstones" , n° SPWLA1966; ou

- Timur, A. :"An investigation of permeability, porosity and residual water saturation relationships" , n° SPWLA1968.

I 1. Mesures pétrophysiques existantes à partir de fragments de roche

La mesure de paramètres pétrophysiques tels que la perméabilité, la porosité et les propriétés capillaires sur des fragments de roche remontés au cours du forage d'un puits au travers d'un formation souterraine, constitue une opportunité intéressante pour les compagnies opératrices d'obtenir rapidement une première caractérisation pétrophysique de zones productrices traversées par le puits.

Par le brevet FR 2 809 821 du demandeur, on connaît un système pour évaluer des paramètres physiques tels que leur perméabilité absolue de roches poreuses d'une zone d'un gisement souterrain, à partir de débris rocheux (« cuttings ») remontés dans la boue d'un forage. Dans une enceinte où les débris sont plongés dans un fluide visqueux, on injecte de ce même fluide sous une pression croissante avec le temps, jusqu'à un seuil de pression définie, de manière à comprimer le gaz piégé dans les pores de la roche. Cette phase d'injection est suivie d'une phase de relaxation avec arrêt de l'injection. L'évolution de la pression durant le processus d'injection ayant été modélisée à partir de valeurs initiales choisies pour les paramètres physiques des débris, un calculateur les ajuste itérativement pour faire coïncider au mieux la courbe de pression modélisée avec la courbe de pression réellement mesurée

Par les demandes de brevet FR 02/0023 et FR 03/03742 du demandeur, on connaît également une autre méthode pour évaluer des paramètres physiques tels que la perméabilité absolue et la porosité des roches d'une zone d'un gisement souterrain, à partir également de débris de forage. Une enceinte contenant les fragments de roche et remplie d'un fluide visqueux est mise en communication avec un réservoir de ce même fluide sous une pression définie de manière à comprimer le gaz piégé dans les pores de la roche. La durée d'application de cette pression selon qu'elle est courte ou plus longue permet de mesurer soit la variation de la pression dans l'enceinte ou la variation du volume effectivement absorbé par les fragments de roche. Ensuite, on modélise l'évolution de la pression ou du volume dans l'enceinte, à partir de valeurs initiales choisies pour les paramètres physiques des fragments, et on ajuste itérativement les valeurs des paramètres physiques des fragments de roche pour que l'évolution modélisée s'ajuste au mieux avec l'évolution mesurée du paramètre physique dans l'enceinte.

I 2. Utilisation de la RMN dans l'industrie pétrolière

La technique de mesure non intrusive dite par RMN pour Résonance Magnétique Nucléaire est connue depuis longtemps. Elle a suscité un engouement très fort dans l'industrie pétrolière depuis une vingtaine d'années grâce aux progrès réalisés dans l'acquisition et le traitement des données. Le principe de cette technique est décrit dans de nombreuses références et notamment par Seevers 1966, Timur 1968, Kenyon 1989, ou Godefroy 2001 déjà cités. De manière très simplifiée, la mesure consiste à exciter préalablement les protons suivant un champ magnétique imposé par l'appareil puis de laisser les protons revenir à leur état initial (relaxation). En milieu poreux, le signal de relaxation magnétique obtenu dépend de la nature des fluides contenus dans la roche mais aussi de la géométrie des pores. Pour un proton, la relaxation (T2) est d'autant plus rapide qu'il se trouve dans un pore de faible extension. T2 est relié à la relaxivité de surface $\rho_2$, la surface S et le volume V par la relation :

$$\frac{1}{T_2} = \rho_2 \frac{S}{V}$$

I 2.1 Évaluation de la porosité

Lorsque la nature du fluide contenu dans les pores est connue, l'amplitude du signal RMN peut être converti en volume. Cela permet d'évaluer directement la quantité de fluide contenu dans la roche, c'est à dire directement la différence entre le volume total de roche et le volume solide ($V_t$-$V_s$). Si le volume total est connu, on peut déduire la valeur de la porosité. Dans un contexte plus orienté vers le laboratoire, le volume total doit être mesuré séparément à l'aide d'un pycnomètre à poudre par exemple ou à partir des dimensions de l'échantillon (carotte).

$$\phi = \frac{V_t - V_s}{V_t}$$

Les appareils de mesure par RMN sont largement utilisés pour réaliser des diagraphies. Dans ce contexte, le volume total correspond au volume de mesure de ces appareils (corrigé des effets de bord).

I 2.2 Évaluation de la perméabilité

Différentes corrélations empiriques ont été proposées pour évaluer la valeur de la perméabilité à partir des caractéristiques de la distribution de T2. La diagraphie RMN a été présentée comme un outil prédictif de mesure de la perméabilité dans le puits. Cette technique a aussi été envisagée pour des mesures sur des déblais puisqu'elle est rapide et souple que ce soit sur champ ou au laboratoire. Les modèles reposent sur une utilisation des mesures de temps T1 et T2 représentant les temps de relaxation respectivement longitudinal et transversal à partir du signal RMN. Une synthèse des modèles existants est donnée dans la référence Fleury et al. (2001) déjà citée. Dans les publications suivantes déjà citées, la perméabilité k est modélisée par les relations empiriques :
Seevers (1966)

$$k = C \, (1 - S_{wi}) \, T_1^2 \phi$$

Timur (1968)

$$k= C\frac{1}{S_{wi}^2}\phi^{4.4}$$

Kenyon (1988)

$$k = C\,T_{2ML}^2\,\phi^4$$

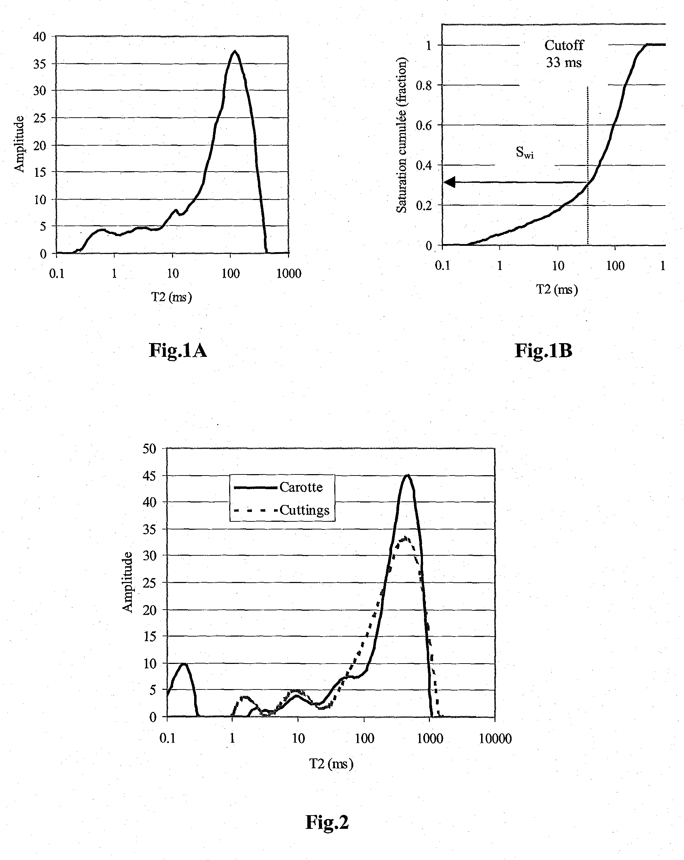

Dans les modèles précédents, la valeur de $S_{wi}$ est obtenue à partir du signal de T2 en considérant la volume qui correspond à des temps de relaxation courts (petits pores) sous un certain seuil de coupure appelé "cutoff". Dans la littérature, les valeurs par défaut de ce "cutoff" sont de 33 ms pour des grès contre 100 ms pour des carbonates (valeurs purement empiriques). Une illustration de l'utilisation du "cutoff" est donnée en figure 1. Toutes ces expressions ont été validées avec succès sur un nombre important d'échantillons faisant parties d'un même groupe pétrophysique.

Lorsque l'on change de groupe pétrophysique, la qualité de la prédiction peut diminuer significativement. Ceci résulte de la mesure RMN qui n'est pas une mesure directe de perméabilité. Ainsi, il est préférable d'utiliser des relations plus générales reliant la perméabilité au signal RMN :

$$k=C\,T_2^a\phi^b,$$

$$k= C\,\frac{1}{S_{wi}^a}\phi^b$$

ou C, a et b dépendent de la structure poreuse.

Ainsi, il faut ajuster les paramètres C, a et b pour obtenir des prédictions satisfaisantes pour chacune des roches.

I 3. Mesures de RMN sur déblais de forage

Au laboratoire

Une technique de mesure par RMN permettant d'obtenir une évaluation de la porosité de déblais obtenus par concassage de carottes de propriétés connues, est décrite de façon très schématique par Santarelli et al. (1998) déjà citée. Seule la comparaison avec les mesures de référence est fournie. Un bon accord est obtenu avec les mesures de référence mais on note une certaine dégradation par rapport à la technique de détente de gaz (hélium) qui se traduit par un coefficient de corrélation moins bon ($R^2$=0.87) et un écart moyen par rapport à la première bissectrice plus important (de l'ordre de 3-4 unités de porosité).

Sur chantier

L'utilisation d'un appareil RMN de chantier permettant de déterminer la porosité et la perméabilité à partir de déblais peu de temps après leur remontée est décrite par Nigh et al (1985). La première étape de la mesure consiste à bien identifier les déblais récupérés en terme de profondeur (calcul du temps de remontée). Il est préconisé d'injecter fréquemment des traceurs dans la boue pour aider au recalage. Pour un forage réalisé avec une boue à base d'eau, les déblais sont d'abord nettoyés dans une cellule de lavage remplie de saumure à 3% NaCl. L'opération est répétée jusqu'à ce que les déblais soient propres. Si une boue à base d'huile a été utilisée, les déblais sont nettoyés avec des solvants. L'équivalent de deux cuillères à café est nécessaire pour faire une mesure. Une fois le nettoyage effectué, les déblais sont examinés pour vérifier qu'ils proviennent bien des niveaux réservoirs correspondants au temps de remontée. Les déblais sélectionnés sont ensuite introduits dans une cellule remplie d'eau et mis sous vide pour les saturer complètement en liquide. Les déblais sont alors retirés de la cellule et placés au contact d'une céramique pour retirer l'eau en surface et le volume total de roche est calculé. La mesure RMN permet de déterminer directement la valeur de la porosité et de la saturation en eau irréductible $S_{wi}$. Les résultats obtenus montrent que la mesure de porosité sous-estime de manière systématique ce que donnent les mesures sur carottes et les logs (diagraphies). Les auteurs attribuent ces différences à des problèmes de recalage en profondeur et au fait que les déblais donnent une valeur correspondant à une profondeur précise alors qu'il existe un effet de moyennage avec les outils de diagraphie (30 cm en moyenne). D'après la procédure de saturation décrite dans la publication (qui n'est pas celle recommandée au niveau du laboratoire : normes API), il est aussi possible qu'une partie du réseau poreux soit restée saturée avec du gaz ce qui pourrait expliquer la sous estimation observée.

## LA METHODE SELON L'INVENTION

La méthode selon l'invention permet de déterminer la perméabilité d'un milieu souterrain à partir de mesures par RMN de la perméabilité de fragments de roche issus du milieu.

Elle comporte :

A) une étape d'étalonnage comprenant :

a) une mesure directe en laboratoire de perméabilité à partir des fragments de roche ;

b) une mesure de paramètres de signaux obtenus par RMN des fragments de roche ; et

c) le calage des paramètres d'une relation empirique choisie qui relie la valeur de la perméabilité à des paramètres déduits des signaux obtenus par RMN, en utilisant les mesures directes réalisées sur les fragments de roche ; et

B) l'utilisation de cette relation optimale pour déterminer la perméabilité du milieu uniquement à partir de diagraphies par RMN pour lesquelles on ne dispose pas de mesures directes de perméabilité.

La mesure directe en laboratoire de la perméabilité à partir des fragments de roche comporte par exemple la mesure des variations de pression à l'intérieur d'un récipient rempli d'un fluide contenant les fragments de roche après sa mise en communication durant un temps défini avec un réservoir de ce même fluide sous pression, la mesure du volume effectivement absorbé par les fragments de roche, et une modélisation de l'évolution de la pression ou du volume dans le récipient, à partir de valeurs initiales choisies pour la perméabilité des fragments de roche, que l'on ajuste itérativement pour que l'évolution modélisée de la pression s'ajuste au mieux avec l'évolution mesurée de la perméabilité des débris de roche.

La méthode comporte par exemple la mesure d'au moins un des temps de relaxation respectivement longitudinal et/ou transversal des signaux de RMN.

La méthode est avantageuse notamment en ce qu'elle fournit un étalonnage des diagraphies RMN de perméabilité sur la base de mesures à partir de simples débris de forage plus facilement disponibles et moins coûteux à obtenir que des carottes. L'étalonnage effectué entre les mesures sur les signaux de RMN et ceux obtenus par des mesures directes permet d'améliorer le degré de prédiction des formules empiriques d'évaluation de la perméabilité. Les résultats sont également obtenus bien plus rapidement qu'avec des carottes.

## II PRESENTATION DES FIGURES

- Les figures 1a, 1b montrent une distribution du temps T2 de relaxation obtenue à partir d'une carotte de grès et la valeur de Swi obtenue à partir de cette distribution en appliquant la valeur de "cutoff" par défaut de 33 ms et une courbe reliant la saturation cumulée à ce même temps T2 ;

- la figure 2 montre une comparaison entre une distribution de T2 obtenue sur carotte perméable et une distribution de T2 obtenue à partir des fragments de roche de la même carotte concassée et égouttée ;

- la figure 3 montre les différentes distributions de T2 obtenues à partir des 8 échantillons de déblais testés appartenant à la même classe de roche, et l'on remarque que les pics de T2 se situent à des valeurs très différentes suivant les échantillons (entre 3 ms et 140 ms) ;

- la figure 4 montre la comparaison entre la valeur de perméabilité obtenue à partir du signal RMN (Formule de Kenyon) en utilisant les paramètres par défaut et la valeur de perméabilité de référence obtenue par mesure directe sur carotte avant concassage. Dans ce cas, l'écart type entre la valeur estimée et la valeur de référence est de l'ordre d'un facteur 10 (11.5) ;

- la figure 5 montre la comparaison entre la valeur de perméabilité obtenue à partir du signal RMN (Formule de Kenyon) après la phase d'étalonnage et la valeur de perméabilité de référence obtenue par mesure directe sur carotte avant concassage ; et

- la figure 6 montre le principe de la méthode d'étalonnage des diagraphies de type RMN et et son utilisation dans le cadre de la caractérisation des formations souterraines.

## III DESCRIPTION DETAILLEE DE LA METHODE

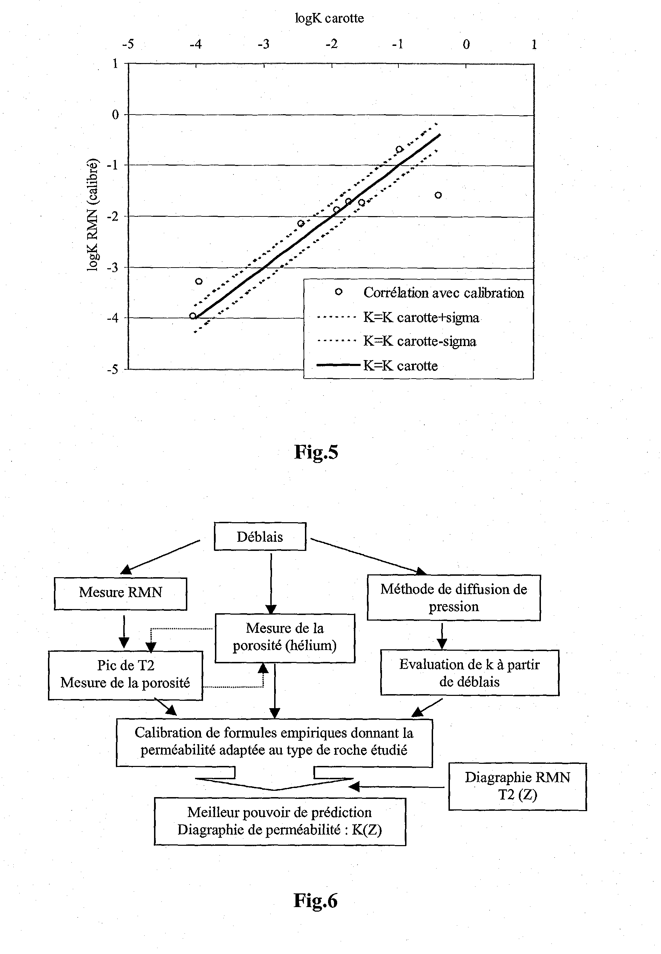

Le principe général de la méthode d'étalonnage des diagraphies RMN à partir de mesures directes sur des fragments de roche est illustré en figure 6. La méthode repose sur trois phases distinctes : mesure de perméabilité et de porosité à partir de fragments de roche préalablement secs, mesure RMN à partir de fragments saturés en liquide et d'étalonnage d'une formule empirique de perméabilité de type Kenyon. Ces trois étapes sont rappelées ci-après avec une illustration pratique à partir d'une série de 8 mesures sur des fragments de roche de même nature mais de propriétés différentes.

III 1. Préparation

On récupère en surface les déblais de forage. Le calcul du temps de remontée permet, comme il est connu de recaler les déblais recueillis par rapport à une profondeur dans le puits. La première étape consiste à nettoyer les déblais avec des procédures adaptées suivant la nature du fluide de forage (boue à l'eau ou boue à l'huile) mais aussi des fluides en place dans le réservoir (huile ou gaz). Une procédure standard consiste à nettoyer les déblais avec des solvants dans un appareil de type Soxhlet, puis de les sécher en étuve à 60°C.

III 2. Mesure de perméabilité et de porosité

Pour mesurer.la perméabilité de fragments de roche, on applique la méthode décrite dans les demandes de brevet français précitée EN 02/02242 ou EN 03/03742. A cet effet, on plonge les fragments de roche dans une enceinte de confinement contenant un fluide visqueux. On met alors l'enceinte en communication avec un récipient contenant ce même fluide sous pression, de manière à comprimer le gaz piégé dans les pores de la roche. Suivant un premier mode de mise en oeuvre, cette mise en communication peut être très brève et suivie après un temps d'attente, d'une mesure de l'évolution de la pression dans l'enceinte. Suivant un autre mode de mise en oeuvre, la mise en communication est assez longue pour que l'on puisse observer et mesurer la variation du volume effectivement absorbé par les fragments de roche.
Ensuite, on modélise l'évolution de la pression ou du volume dans l'enceinte, à partir de valeurs initiales choisies pour la perméabilité et on ajuste itérativement la valeur de celle-ci pour que l'évolution modélisée s'ajuste au mieux avec l'évolution mesurée des paramètres mesurés dans l'enceinte.
Cette procédure donne d'excellents résultats. Les valeurs de perméabilité k des fragments de roche sont tout à fait conformes aux mesures de référence obtenues à partir de carottes.
Pour mesurer la porosité des fragments de roche, on applique la méthode décrite dans la demande de brevet français précitée EN 03/03742. On utilise alors la méthode classique d'expansion du gaz (détente à l'hélium) pour obtenir la valeur du volume solide de la roche et un pycnomètre à poudre pour obtenir la valeur du volume total (volume enveloppe) des déblais. On obtient ainsi une mesure de la porosité des déblais secs.

III 3. Mesure de RMN sur les déblais

Une autre partie des déblais préalablement nettoyés est utilisée pour réaliser les mesures RMN. On mesure préalablement les volumes totaux des déblais utilisés avec un pycnomètre à poudre. Les déblais sont ensuite saturés avec de la saumure 20 g/l. Les fragments de roche sont ensuite égouttés dans un tissu humide de manière à éliminer l'eau piégée entre les différents fragments de roche. Il est aussi possible d'utiliser une céramique poreuse pour drainer l'eau située entre les fragments.
Les déblais égouttés sont ensuite introduits dans l'appareil de mesure RMN ce qui permet d'obtenir une distribution de T2. Des essais préalables ont prouvé que la distribution de T2 obtenue à partir de fragments de roche, est similaire à la distribution obtenue à partir d'une carotte de la même roche tant en ce qui concerne la forme que de la localisation du pic de T2 comme le montre la figure 2, ce qui est particulièrement important dans le cadre de l'étalonnage des formules de perméabilité.
Comme on connaît la nature du fluide qui sature les fragments de roche, on peut calculer le volume de fluide qui sature la roche, c'est-à-dire directement $V_t - V_s$. Comme on a mesuré Vt par ailleurs, on peut déduire une mesure de la porosité. Cette valeur de porosité est alors comparée à la valeur de porosité obtenue sur les déblais secs par détente hélium ce qui permet de détecter un éventuel problème d'égouttage avant le passage dans l'appareil RMN.

III 4. Résultats obtenus

Les techniques de mesures précédentes ont été appliquées pour une série de 8 échantillons de fragments de roche, de même nature mais de propriétés différentes, obtenus par concassage de carotte sur lesquelles on a préalablement mesuré la perméabilité. L'ensemble des échantillons appartiennent à la même famille de roche de type carbonaté.

L'ensemble des résultats a été rassemblé dans le tableau ci-après.

| Nom | Phi % | T2 (pic) ms | K référence carotte md | K fragments md | K RMN défaut md | K RMN optimisé md |
|-----|-------|-------------|-------------------------|-----------------|------------------|-------------------|
| E1 | 2.75 | 3.07 | 9.0E-05 | 1.1E-04 | 5.4E-07 | 1.1E-04 |
| E2 | 8.00 | 27.46 | 3.5E-03 | 1.3E-02 | 3.1E-03 | 7.4E-03 |
| E3 | 9.77 | 47.5 | 1.8E-02 | 2.4E-02 | 2.1E-02 | 1.9E-02 |
| E4 | 7.89 | 62.45 | 2.8E-02 | 4.2E-02 | 1.5E-02 | 1.9E-02 |
| E5 | 19.79 | 142 | 1.0E-01 | 1.5E-01 | 3.1E+00 | 2.0E-01 |
| E6 | 8.75 | 41.4 | 1.2E-02 | 3.7E-02 | 1.0E-02 | 1.4E-02 |
| E7 | 10.90 | 54.5 | 3.9E-01 | 2.4E-01 | 4.2E-02 | 2.7E-02 |
| E8 | 3.29 | 9.18 | 1.1E-04 | 4.0E-04 | 9.9E-06 | 5.2E-04 |

Sur la base de la loi de Kenyon, une relation générale a été utilisée pour évaluer la valeur de la perméabilité à partir du signal RMN :

$$k = C\, T_{2\,pic}^{a}\, \phi^{b}$$

Les paramètres préconisés par Kenyon pour les roches carbonatés sont C=0.1, a=2 et b = 4

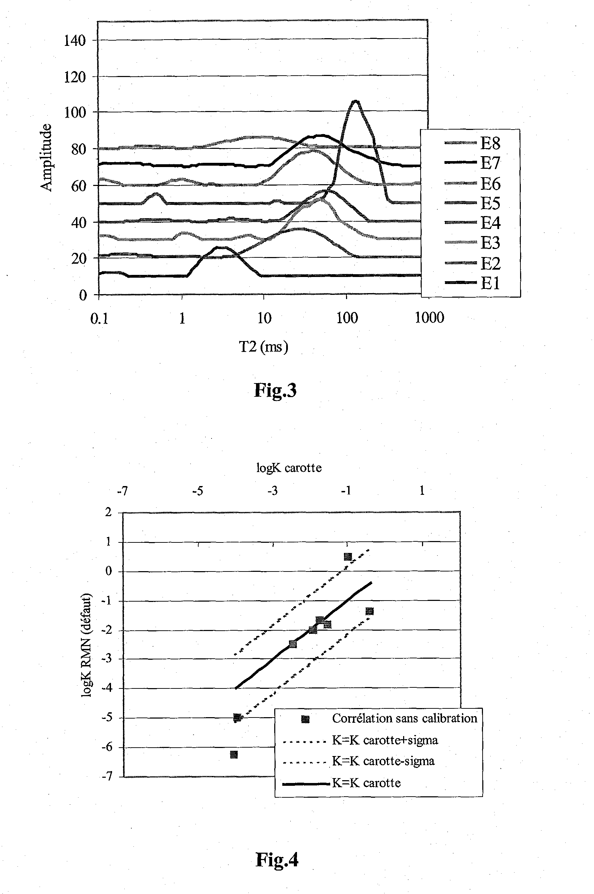

Les résultats obtenus avec cette loi sont rappelés à la figure 4. Ils montrent que l'écart type par rapport aux mesures de référence sur carotte est de l'ordre d'une dizaine ce qui n'est pas satisfaisant dans le cadre de l'évaluation des propriétés d'un réservoir souterrain.

Les paramètres de la loi de Kenyon ont ensuite été optimisés à partir des mesures directes de perméabilité obtenues sur les fragments de roche. On obtient alors le jeu de paramètres suivants: C=0.0086, a=1.15 et b=1.57.

Les résultats obtenus avec cette loi sont rappelés en figure 5. Ils montrent que l'écart type par rapport aux mesures de référence sur carotte est réduit de manière significative par rapport au cas précédent où on utilisait les paramètres par défaut. Dans ce cas, l'écart type entre la valeur calculée et la valeur de référence est bien meilleur par rapport au cas où on utilise des paramètres par défaut (un facteur 2 contre un facteur 10 auparavant). L'écart type est ici ramené à 2.5 ce qui est tout à fait satisfaisant.

La formule ainsi optimisée peut être appliquée à l'ensemble des diagraphies RMN disponibles dans les zones correspondants à ce type de roche et pour lesquelles on ne dispose pas de mesures directes de perméabilités.

Si le réservoir comporte plusieurs types de roche, il est tout à fait possible de répéter l'opération précédente pour chaque famille de roche identifiée. Cela permet ainsi d'appliquer la formule de calcul de perméabilité la plus adaptée et la plus prédictive en fonction de la nature de la roche le long du puits.


**Revendications**

1. Méthode pour déterminer la perméabilité d'un milieu souterrain à partir de mesures par RMN de la perméabilité de fragments de roche issus du dit milieu, comportant :

    A) une étape d'étalonnage comprenant :

        a) une mesure directe en laboratoire de perméabilité à partir des fragments de roche ;

        b) une mesure de paramètres de signaux obtenus par RMN des fragments de roche ; et

c) le calcul des paramètres d'une relation empirique choisie qui relie la valeur de la perméabilité à des paramètres déduit des signaux obtenus par RMN, en utilisant les mesures directes réalisées sur les fragments de roche ; et

B) l'utilisation du paramétrage pour déterminer la perméabilité du milieu uniquement à partir de diagraphies par RMN pour lesquelles on ne dispose pas de mesures directes de perméabilité.

**2.** Méthode selon la revendication 1, dans laquelle la mesure directe en laboratoire de la perméabilité à partir des fragments de roche comporte la mesure des variations de pression à l'intérieur d'un récipient rempli d'un fluide contenant les fragments de roche après sa mise en communication durant un temps défini avec un réservoir de ce même fluide sous pression, la mesure du volume effectivement absorbé par les fragments de roche, et une modélisation de l'évolution de la pression ou du volume dans le récipient, à partir de valeurs initiales choisies pour la perméabilité des fragments de roche, que l'on ajuste itérativement pour que l'évolution modélisée de la pression s'ajuste au mieux avec l'évolution mesurée de la perméabilité des débris de roche.

**3.** Méthode selon la revendication 1 ou 2, dans laquelle on mesure au moins un des temps (T1, T2) de relaxation respectivement longitudinal et/ou transversal des signaux de RMN.

**Fig.1A**

**Fig.1B**

**Fig.2**

**Fig.3**

**Fig.4**

logK carotte

**Fig.5**

**Fig.6**

**Office européen des brevets**

**RAPPORT DE RECHERCHE EUROPEENNE**

Numéro de la demande

EP 04 29 2896

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | FLEURY M ET AL: "Validity of permeability prediction from NMR measurements" COMPTES RENDUS DE L'ACADEMIE DES SCIENCES SERIES IIC CHEMISTRY, vol. 4, no. 11, novembre 2001 (2001-11), pages 869-872, XP002289453 Sections "Correlation laws", "T2 measurements", "Conclusion"* figures 2,4 * | 1,3 | G01R33/44 |
| Y | | 2 | |
| X | US 6 008 645 A (BOWERS MARK C ET AL) 28 décembre 1999 (1999-12-28) * colonne 5, ligne 8 - colonne 7, ligne 32; figure 2 * | 1,3 | |
| X | TIMUR A: "PULSED NUCLEAR MAGNETIC RESONANCE STUDIES OF POROSITY, MOVABLE FLUID, AND PERMEABILITY OF SANDSTONES" JOURNAL OF PETROLEUM TECHNOLOGY, AIME, DALLAS, TX, US, juin 1969 (1969-06), pages 775-786, XP008014691 ISSN: 0149-2136 page 784-785, sections "Permeability", "Samples with irregular shapes and small size" | 1,3 | |
| X | US 5 387 865 A (JEROSCH-HEROLD MICHAEL ET AL) 7 février 1995 (1995-02-07) * colonne 3, ligne 58 - colonne 6, ligne 16 * * colonne 11, ligne 36 - colonne 12, ligne 2 * * colonne 13, ligne 55-58 * * figure 9 * | 1,3 | |

DOMAINES TECHNIQUES RECHERCHES (Int.Cl.7)

G01R

-/--

Le présent rapport a été établi pour toutes les revendications

| Lieu de la recherche | Date d'achèvement de la recherche | Examinateur |
|---|---|---|
| Munich | 14 mars 2005 | Streif, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
......................................................................................
& : membre de la même famille, document correspondant

EPO FORM 1503 03.82 (P04C02)

**Office européen des brevets**

**RAPPORT DE RECHERCHE EUROPEENNE**

Numéro de la demande

EP 04 29 2896

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | EGERMANN P ET AL: "A fast and direct method of permeability measurements on drill cuttings" PROCEEDINGS OF THE 2002 SPE ANNUAL TECHNICAL CONFERENCE AND EXHIBITION, SAN ANTONIO, TX, US, 29 SEP - 02 OCT 2002, 29 septembre 2002 (2002-09-29), pages 1993-2000, XP009034279 * le document en entier * ----- | 2 | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| Munich | 14 mars 2005 | Streif, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................................
& : membre de la même famille, document correspondant

EPO FORM 1503 03.82 (P04C02)

**EP 1 548 455 A1**

**ANNEXE AU RAPPORT DE RECHERCHE EUROPEENNE
RELATIF A LA DEMANDE DE BREVET EUROPEEN NO.**

EP 04 29 2896

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-03-2005

| Document brevet cité au rapport de recherche | | Date de publication | Membre(s) de la famille de brevet(s) | | Date de publication |
|---|---|---|---|---|---|
| US 6008645 | A | 28-12-1999 | CA | 2272997 A1 | 17-09-1998 |
| | | | GB | 2337821 A ,B | 01-12-1999 |
| | | | NO | 994393 A | 10-09-1999 |
| | | | WO | 9840763 A1 | 17-09-1998 |
| US 5387865 | A | 07-02-1995 | US | 5289124 A | 22-02-1994 |
| | | | AU | 672274 B2 | 26-09-1996 |
| | | | AU | 5765394 A | 15-09-1994 |
| | | | BR | 9401108 A | 08-11-1994 |
| | | | CA | 2118736 A1 | 12-09-1994 |
| | | | GB | 2276007 A ,B | 14-09-1994 |
| | | | NO | 940808 A | 12-09-1994 |
| | | | AU | 653632 B2 | 06-10-1994 |
| | | | AU | 2456892 A | 25-03-1993 |
| | | | BR | 9203665 A | 13-04-1993 |
| | | | CA | 2078474 A1 | 21-03-1993 |
| | | | GB | 2260820 A ,B | 28-04-1993 |
| | | | MX | 9205308 A1 | 01-07-1993 |
| | | | NO | 923630 A | 22-03-1993 |

EPO FORM P0460

Pour tout renseignement concernant cette annexe : voir Journal Officiel de l'Office européen des brevets, No.12/82